# EUROPEAN PATENT APPLICATION

(11) **EP 4 411 032 A1**
(43) Date of publication of application: **07.08.2024**
(21) Application number: 22875715.9
(22) Date of filing: 02.09.2022
(51) Int. Cl.: C30B 33/04, H01L 21/205, H01L 21/263, H01L 21/322, C30B 29/38

(54) **NITRIDE SEMICONDUCTOR WAFER PRODUCTION METHOD AND NITRIDE SEMICONDUCTOR WAFER**

(30) Priority: 01.10.2021 JP 2021162883
(71) Applicant: Shin-Etsu Handotai Co., Ltd., Tokyo 100-0004 (JP)
(72) Inventor: HAGIMOTO, Kazunori, Annaka-shi, Gunma 379-0196 (JP)
(74) Representative: Mooser, Sebastian Thomas
(86) International application number: PCT/JP2022/033082
(87) International publication number: WO 2023/053843

(57) **Abstract**

The present invention is a method for manufacturing a nitride semiconductor wafer in which a nitride semiconductor film is formed on a silicon single-crystal substrate, the method including: a step of forming the nitride semiconductor film on the silicon single-crystal substrate; and a step of irradiating the silicon single-crystal substrate with electron beam so that the silicon single-crystal substrate has a higher resistivity than a resistivity before the irradiation, wherein a substrate doped with nitrogen at a concentration of 5×10¹⁴ atoms/cm³ or more and 5×10¹⁶ atoms/cm³ or less is used as the silicon single-crystal substrate. This provides a method for manufacturing a nitride semiconductor wafer having a nitride semiconductor film grown on a silicon single-crystal substrate, wherein the method makes it possible that a silicon single-crystal substrate having been irradiated with electron beam and thereby has an increased resistivity is prevented from recovering and having a lower resistivity during the epitaxial growth or other thermal treatment steps.

## Description

### TECHNICAL FIELD

The present invention relates to a nitride semiconductor wafer and a method for manufacturing the same, and specifically relates to a method for manufacturing a nitride semiconductor wafer suitably used for a high-frequency device.

### BACKGROUND ART

For miniaturization and cost reduction of a high-frequency device, development of integrating devices such as antenna, an amplifier, a switch, and a filter has been in progress. As the frequency has been increased, the circuit has become complex, and various materials of the devices such as devices using a silicon CMOS, III-V group semiconductors, or a nitride semiconductor, and filters using a piezoelectric material have been used. For a substrate to be a base of these devices, a silicon single-crystal substrate in which inexpensive and large-sized wafers are distributed is considered to be suitable.

### CITATION LIST

### PATENT LITERATURE

Patent Document 1: WO 2005/020320 A1

### SUMMARY OF INVENTION

### TECHNICAL PROBLEM

However, the conventional high-frequency device as above causes deterioration of characteristics derived from the substrate, loss due to the substrate, and deterioration of second and third higher harmonic characteristics due to the substrate.

Here, the higher harmonic refers to a higher frequency component having an integer multiple frequency of an original frequency. When the original frequency is defined as a fundamental wave, a wave having a double frequency (a half wavelength) of the original wave is defined as the second higher harmonic, and a wave having a triple frequency (one-third wavelength) of the original wave is defined as the third higher harmonic. A high-frequency circuit requires a substrate with reduced higher harmonic in order to avoid interference due to the higher harmonic.

Patent Document 1 describes that a wide-gap bipolar semiconductor (SiC) for power application is irradiated with one of γ-ray, electron beam, and charged particle beam in advance for regulating a carrier lifetime within a predetermined range to improve switching characteristics. However, Patent Document 1 does not refer to deterioration of the second harmonic characteristics.

The present inventors have found that the high-frequency characteristics can be improved by increasing the resistivity of the substrate by irradiating the silicon single-crystal substrate with electron beam regardless of a substrate resistivity. However, annealing or epitaxial growth after the electron beam irradiation may recover and decrease the resistivity.

The present invention has been made to solve the above problem. An object of the present invention is to provide a method for manufacturing a nitride semiconductor wafer having a nitride semiconductor film grown on a silicon single-crystal substrate, wherein the method makes it possible that a silicon single-crystal substrate having been irradiated with electron beam and thereby has an increased resistivity is prevented from recovering and having a lower resistivity during the epitaxial growth or other thermal treatment steps.

### SOLUTION TO PROBLEM

To solve the above problem, the present invention provides a method for manufacturing a nitride semiconductor wafer in which a nitride semiconductor film is formed on a silicon single-crystal substrate, the method comprising:
a step of forming the nitride semiconductor film on the silicon single-crystal substrate; and
a step of irradiating the silicon single-crystal substrate with electron beam so that the silicon single-crystal substrate has a higher resistivity than a resistivity before the irradiation,
wherein a substrate doped with nitrogen at a concentration of 5×10¹⁴ atoms/cm³ or more and 5×10¹⁶ atoms/cm³ or less is used as the silicon single-crystal substrate.

Such a method for manufacturing a nitride semiconductor wafer makes it possible that a silicon single-crystal substrate having been irradiated with electron beam and thereby has an increased resistivity is prevented from recovering and having a lower resistivity during the epitaxial growth or other thermal treatment steps.

In the step of irradiating the substrate with electron beam, the irradiated electron beam preferably has an irradiation dose of 1×10¹⁴ e/cm² or more and 1×10¹⁶ e/cm² or less.

With the irradiation dose of the electron beam set within such a range, the nitride semiconductor wafer with furthermore improved loss and inhibited deterioration of the second higher harmonic characteristics can be manufactured, and the irradiation dose is efficient because the time for irradiation is not excessively long.

In the present invention, the step of irradiating the substrate with electron beam may be performed before the step of forming the nitride semiconductor film.

In the present invention, the steps may be performed in such an order.

In the present invention, the step of irradiating the substrate with electron beam may be performed after the step of forming the nitride semiconductor film.

Such an order can certainly avoid decrease in the resistivity due to the epitaxial growth.

In addition, the present invention also provides a nitride semiconductor wafer comprising:
a silicon single-crystal substrate; and
a nitride semiconductor film formed on the silicon single-crystal substrate,
wherein the silicon single-crystal substrate is doped with nitrogen at a concentration of 5×10¹⁴ atoms/cm³ or more and 5×10¹⁶ atoms/cm³ or less, and is a substrate irradiated with electron beam.

Such a nitride semiconductor wafer makes it possible that a silicon single-crystal substrate having been irradiated with electron beam and thereby has an increased resistivity is prevented from recovering and having a lower resistivity during the epitaxial growth or other thermal treatment steps.

### ADVANTAGEOUS EFFECTS OF INVENTION

As above, in a high-frequency device manufactured from a nitride semiconductor wafer having a nitride semiconductor film grown on a silicon single-crystal substrate, with the method for manufacturing a nitride semiconductor wafer of the present invention, it is possible to prevent the resistivity of the substrate increased by electron beam irradiation for improving the loss and second harmonic characteristics due to the substrate, from recovering and becoming a lower resistivity during epitaxial growth or other heat treatment steps.

### BRIEF DESCRIPTION OF DRAWINGS

FIG. 1 is an example of a schematic view of a cross-sectional structure of a nitride semiconductor wafer manufactured in the present invention; and
FIG. 2 is a cross-sectional SEM image of a nitride semiconductor wafer manufactured in Example.

### DESCRIPTION OF EMBODIMENTS

As described above, there has been a demand for development of a method for manufacturing a nitride semiconductor wafer having a nitride semiconductor film grown on a silicon single-crystal substrate, wherein the method makes it possible that the silicon single-crystal substrate having been irradiated with electron beam and thereby has an increased resistivity is prevented from recovering and having a lower resistivity during the epitaxial growth or other thermal treatment steps.

The present inventors have earnestly studied the above problem, and consequently found that, by doping the silicon single-crystal substrate with a predetermined concentration of nitrogen in advance, the substrate's resistivity increased by electron beam irradiation does not return to the value before electron beam irradiation during a subsequent thermal treatment. This finding has led to completion of the present invention.

Specifically, the present invention is a method for manufacturing a nitride semiconductor wafer in which a nitride semiconductor film is formed on a silicon single-crystal substrate, the method comprising: a step of forming the nitride semiconductor film on the silicon single-crystal substrate; and a step of irradiating the silicon single-crystal substrate with electron beam so that the silicon single-crystal substrate has a higher resistivity than a resistivity before the irradiation, wherein a substrate doped with nitrogen at a concentration of 5×10¹⁴ atoms/cm³ or more and 5×10¹⁶ atoms/cm³ or less is used as the silicon single-crystal substrate.

Hereinafter, the present invention will be described in detail, but the present invention is not limited thereto.

### [Method for Manufacturing Nitride Semiconductor Wafer]

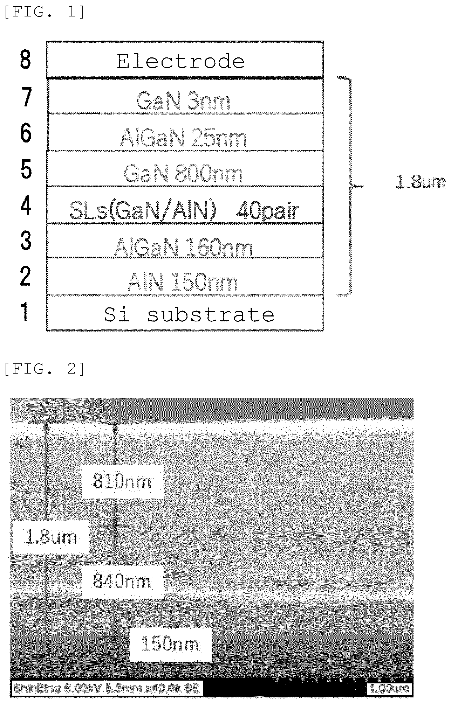

The method for manufacturing a nitride semiconductor wafer of the present invention will be described by using FIG. 1. The following structure of the nitride semiconductor wafer is an example, and the structure is not limited thereto. Hereinafter, the present invention will be described with a case where the step of irradiating the substrate with electron beam is performed before the step of forming the nitride semiconductor film as an example, but in the present invention, the step of forming the nitride semiconductor film may be performed before the step of irradiating the substrate with electron beam.

### <Silicon Single-Crystal Substrate>

First, a silicon single-crystal substrate is prepared. This silicon single-crystal substrate is doped with nitrogen at a concentration of 5×10¹⁴ atoms/cm³ or more and 5×10¹⁶ atoms/cm³ or less. Setting the nitrogen concentration to 5×10¹⁴ atoms/cm³ or more can yield an effect of preventing development of dislocation to prevent the resistivity increased by electron beam irradiation, described later, from returning to the original resistivity. Setting the nitrogen concentration to 5×10¹⁶ atoms/cm³ or less can inhibit decrease in the single-crystalizing rate in growing the nitrogen-doped single crystal.

The resistivity of this prepared silicon single-crystal substrate is not particularly limited, and a substrate having a high resistivity of 100 Qcm or higher may be used, for example. The upper limit value of the resistivity is not particularly limited, and may be 10000 Qcm or lower, for example. A substrate having a normal resistivity of 1 Qcm or higher and lower than 100 Qcm, or a substrate having a low resistivity of lower than 1 Qcm may also be used.

A silicon single-crystal substrate having a higher resistivity is more preferable from the viewpoint that the resistivity can be more increased by electron beam irradiation to sufficiently obtain the effect of the present invention.

### <Step of Irradiating Substrate with Electron Beam>

Then, the aforementioned silicon single-crystal substrate is irradiated with electron beam so that the silicon single-crystal substrate has a higher resistivity than a resistivity before the irradiation.

Irradiating the substrate with electron beam remarkably yields an effect of deactivating a dopant and/or a carrier such as impurities derived from a raw material in the silicon single-crystal substrate. The deactivation is caused by a reaction between point defects and the dopant and/or the carrier: for example, point defects are formed in the silicon single-crystal substrate by electron beam irradiation and the point defects trap carriers in the silicon single-crystal substrate. It is considered that the point defects decrease the mobility of the dopant and/or the carrier to change the resistivity. It is considered that deactivating the dopant and/or the carrier in the silicon single-crystal substrate consequently increases the resistivity of the silicon single-crystal substrate.

The irradiation conditions of electron beam is not particularly limited, and for example, the electron beam irradiation is performed at 2 MeV and 1×10¹⁴ e/cm² or more and 1×10¹⁶ e/cm² or less. This electron beam irradiation is more preferably performed at 1×10¹⁵ e/cm² or more and 1×10¹⁶ e/cm² or less.

With the electron beam irradiation at 1×10¹⁴ e/cm² or more as above, the nitride semiconductor wafer with furthermore improved loss and inhibited deterioration of the second higher harmonic characteristics can be manufactured. The irradiation at 1×10¹⁶ e/cm² or less is efficient because the time for irradiation is not excessively long.

The irradiation energy of electron beam is also not particularly limited, and electron having an energy of 250 keV or higher may be used, for example. With approximately 250 keV or higher, the point defects can be more certainly formed in the silicon single-crystal substrate, and the dopant and/or the carrier such as impurities derived from a raw material in the silicon single-crystal substrate can be deactivated. The upper limit of the irradiation energy is not particularly limited.

This electron beam irradiation may be performed after growing the nitride semiconductor film described later. Such an order can certainly avoid decrease in the resistivity due to the epitaxial growth.

The electron beam irradiation as above can increase the resistivity of the silicon single-crystal substrate higher than a resistivity before the irradiation.

### <Step of Forming Nitride Semiconductor Film>

Then, a nitride semiconductor film is epitaxially grown on the silicon single-crystal substrate. The nitride semiconductor film to be grown is not particularly limited, and may be a single layer or a multilayer as long as the film has at least one nitride semiconductor layer.

For example, for forming a plurality of nitride semiconductor layers as the nitride semiconductor film, an intermediate layer is firstly formed as illustrated in FIG. 1. As for the intermediate layer, an AlN layer 2 with, for example, 150 nm in thickness may be formed on a silicon single-crystal substrate 1, an AlGaN layer 3 with, for example, 160 nm in thickness may be formed thereon, and a super lattice layer (SLs) 4 in which GaN layers and AlN layers are alternately stacked with, for example, 40 pairs may be further formed.

Then, a device layer is formed. As for the device layer, a GaN layer 5 with, for example, 800 nm in thickness may be formed, an AlGaN layer 6 with, for example, 25 nm in thickness may be formed thereon, and a GaN layer 7 with, for example, 3 nm in thickness may be further formed.

The total film thickness of the formed nitride semiconductor film may be, for example, 0.1 to 20 um, preferably 0.5 to 10 µm, more preferably 1 to 5 µm, and particularly 1.8 µm.

Then, the epitaxially grown nitride semiconductor wafer is taken out, and an electrode 8 may be formed in a photolithographic step.

The high-frequency device manufactured from the nitride semiconductor wafer irradiated with electron beam as above can have inhibited deterioration of the second higher harmonic characteristics. Since the silicon single-crystal substrate is doped with nitrogen at a concentration of 5×10¹⁴ atoms/cm³ or more and 5×10¹⁶ atoms/cm³ or less, the resistivity increased by electron beam irradiation is prevented from recovering during the epitaxial growth and other thermal treatments to return to the original resistivity.

### [Nitride Semiconductor Wafer]

In addition, the present invention also provides a nitride semiconductor wafer comprising: a silicon single-crystal substrate; and a nitride semiconductor film formed on the silicon single-crystal substrate, wherein the silicon single-crystal substrate is doped with nitrogen at a concentration of 5×10¹⁴ atoms/cm³ or more and 5×10¹⁶ atoms/cm³ or less, and is a substrate irradiated with electron beam.

Such a nitride semiconductor wafer makes it possible that a silicon single-crystal substrate having been irradiated with electron beam and thereby has an increased resistivity is prevented from recovering and having a lower resistivity during the epitaxial growth or other thermal treatment steps.

### EXAMPLE

Hereinafter, the present invention will be specifically described by using Examples and Comparative Examples, but the present invention is not limited thereto.

### (Example 1 and Comparative Example 1)

The following substrates for recovery thermal treatment were prepared.
Example 1: 471 Qcm (CZ method, N-doped at 5×10¹⁴ atoms/cm³)
Comparative Example 1: 37 Qcm (CZ method, no N-doped)

The above substrate for recovery thermal treatment was irradiated with electron beam at 2 MeV and 1×10¹⁶ e/cm², and the substrate for recovery thermal treatment irradiated with electron beam was subjected to a defect-recovering thermal treatment in a hydrogen atmosphere in an MOCVD furnace at 1200°C for 90 minutes at 100 mbar to check change in the resistivity.

It was confirmed that the N-doped single-crystal substrate (471 Qcm) by CZ method in Example 1 had an increased resistivity of 20568 Qcm after the electron beam irradiation, and the resistivity did not return to the original resistivity and was still an increased resistivity of 3041 Qcm even after subsequent hydrogen thermal treatment. It was confirmed that the CZ single-crystal substrate (37 Qcm) in Comparative Example 1 had an increased resistivity of 1892 Qcm by the electron beam irradiation, but the resistivity returned to near the original resistivity before the electron beam irradiation (67 Qcm) by the subsequent hydrogen thermal treatment.

### (Example 2 and Comparative Examples 2 and 3)

The following substrates for epitaxial growth were prepared.
Example 2: 100 Qcm (CZ method, N-doped at 5×10¹⁴ atoms/cm³)
Comparative Example 2: 4344 Qcm (FZ method, no N-doped)
Comparative Example 3: 13 Qcm (CZ method, no N-doped)

The above substrate for epitaxial growth was irradiated with electron beam at 2 MeV and 1×10¹⁶ e/cm², and the substrate for epitaxial growth irradiated with electron beam was subjected to 1.8-um HEMT epitaxial growth in an MOCVD furnace illustrated in FIG. 1 to check change in the resistivity. FIG. 2 shows a cross-sectional SEM image of the epitaxially grown substrate.

It was confirmed that the N-doped single-crystal substrate (100 Qcm) by CZ method in Example 2 had an increased resistivity of 7942 Qcm after the electron beam irradiation, and the resistivity did not return to the original resistivity and was still an increased resistivity of 3108 Qcm even after the subsequent 1.8-µm HEMT epitaxial growth. It was confirmed that the FZ single-crystal substrate (4344 Qcm) in Comparative Example 2 and the CZ single-crystal substrate (13 Qcm) in Comparative Example 3 had an increased resistivity (202211 Qcm and 50713 Qcm) by the electron beam irradiation, but the resistivity returned to near the original resistivity before the electron beam irradiation (4922 Qcm and 14 Qcm) after the 1.8-um HEMT epitaxial growth.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for manufacturing a nitride semiconductor wafer in which a nitride semiconductor film is formed on a silicon single-crystal substrate, the method comprising:
a step of forming the nitride semiconductor film on the silicon single-crystal substrate; and
a step of irradiating the silicon single-crystal substrate with electron beam so that the silicon single-crystal substrate has a higher resistivity than a resistivity before the irradiation,
wherein a substrate doped with nitrogen at a concentration of 5×10¹⁴ atoms/cm³ or more and 5×10¹⁶ atoms/cm³ or less is used as the silicon single-crystal substrate.

2. The method for manufacturing a nitride semiconductor wafer according to claim 1, wherein, in the step of irradiating the substrate with electron beam, the irradiated electron beam has an irradiation dose of 1×10¹⁴ e/cm² or more and 1×10¹⁶ e/cm² or less.

3. The method for manufacturing a nitride semiconductor wafer according to claim 1 or 2, wherein the step of irradiating the substrate with electron beam is performed before the step of forming the nitride semiconductor film.

4. The method for manufacturing a nitride semiconductor wafer according to claim 1 or 2, wherein the step of irradiating the substrate with electron beam is performed after the step of forming the nitride semiconductor film.

5. A nitride semiconductor wafer, comprising:
a silicon single-crystal substrate; and
a nitride semiconductor film formed on the silicon single-crystal substrate,
wherein the silicon single-crystal substrate is doped with nitrogen at a concentration of 5×10¹⁴ atoms/cm³ or more and 5×10¹⁶ atoms/cm³ or less, and is a substrate irradiated with electron beam.
